# EUROPEAN PATENT APPLICATION

(11) **EP 2 940 712 A1**
(43) Date of publication of application: **04.11.2015**
(21) Application number: 15165195.7
(22) Date of filing: 27.04.2015
(51) Int. Cl.: H01J 37/32

(54) **DRY CLEANING METHOD AND PLASMA PROCESSING APPARATUS**

(30) Priority: 28.04.2014 JP 2014092679
(71) Applicant: TOKYO ELECTRON LIMITED, Minato-ku Tokyo 107-6325 (JP)
(72) Inventor: Ishikawa, Yoshio, Miyagi, 981-3629 (JP); Gao, Jun, Miyagi, 981-3629 (JP); Kaino, Hidemasa, Miyagi, 981-3629 (JP)
(74) Representative: Hoffmann Eitle

(57) **Abstract**

A dry cleaning method is provided that is implemented by a plasma processing apparatus including a processing chamber having a member containing chromium, a mounting table arranged within the processing chamber and configured to hold a substrate, and a gas supply source configured to supply gas into the processing chamber. The dry cleaning method includes a first process step of supplying a first cleaning gas containing oxygen into the processing chamber, supplying a high frequency power or a microwave power into the processing chamber, and generating a plasma from the first cleaning gas; and a second process step of supplying a second cleaning gas containing bromine into the processing chamber after the first process step.

## Description

### BACKGROUND OF THE INVENTION

### 1. The present invention relates to a dry cleaning method and a plasma processing apparatus.

### 2. Description of the Related Art

When a plasma process such as plasma etching is performed within a processing chamber, a member within the processing chamber may be exposed to plasma and corroded, thereby causing contamination within the processing chamber. This in turn may cause contamination of a substrate that is processed within the processing chamber. Accordingly, a technique is known that involves arranging the processing chamber between a valve for introducing gas within the processing chamber and an exhaust valve for discharging gas out of the processing chamber and periodically repeating the processes of purging and vacuuming the processing chamber (see e.g., Japanese Laid-Open Patent Publication No. H08-181112). According to this technique, the pressure within the processing chamber is substantially changed to cause convection of gas within the processing chamber and thereby enable dust floating within the processing chamber or attached to a member within the processing chamber to be evacuated.

Metal contamination of a metal member within the processing chamber causes degradation in the plasma processing performance. Particularly, in a FEOL (front-end-of-line) process step for forming a transistor in a semiconductor manufacturing process, contamination of metal affects the characteristics of the transistor. Therefore, metal contamination within the processing chamber is preferably reduced as much as possible.

### SUMMARY OF THE INVENTION

In view of the above, an aspect of the present invention is directed to reducing metal contamination within the processing chamber.

According to one embodiment of the present invention, a dry cleaning method is provided that is implemented by a plasma processing apparatus including a processing chamber having a member containing chromium, a mounting table arranged within the processing chamber and configured to hold a substrate, and a gas supply source configured to supply gas into the processing chamber. The dry cleaning method includes a first process step of supplying a first cleaning gas containing oxygen into the processing chamber, supplying a high frequency power or a microwave power into the processing chamber, and generating a plasma from the first cleaning gas; and a second process step of supplying a second cleaning gas containing bromine into the processing chamber after the first process step.

### BRIEF DESCRIPTION OF THE DRAWINGS

FIG. 1 illustrates an overall configuration of a plasma processing apparatus according to an embodiment of the present invention;
FIG. 2 is a flowchart illustrating a dry cleaning method implemented by a plasma processing apparatus according to an embodiment of the present invention;
FIG. 3 illustrates exemplary results of executing a dry cleaning method according to an embodiment of the present invention;
FIG. 4 illustrates exemplary results of executing the dry cleaning method under various process conditions; and
FIG. 5 illustrates exemplary results of executing the dry cleaning method using various high frequency powers.

### DESCRIPTION OF THE PREFERRED EMBODIMENTS

In the following, embodiments of the present invention are described with reference to the accompanying drawings. Note that in the following descriptions and accompanying drawings, elements having substantially the same functions or features may be given the same reference numerals and overlapping descriptions thereof may be omitted.

### [Overall Configuration of Plasma Processing Apparatus]

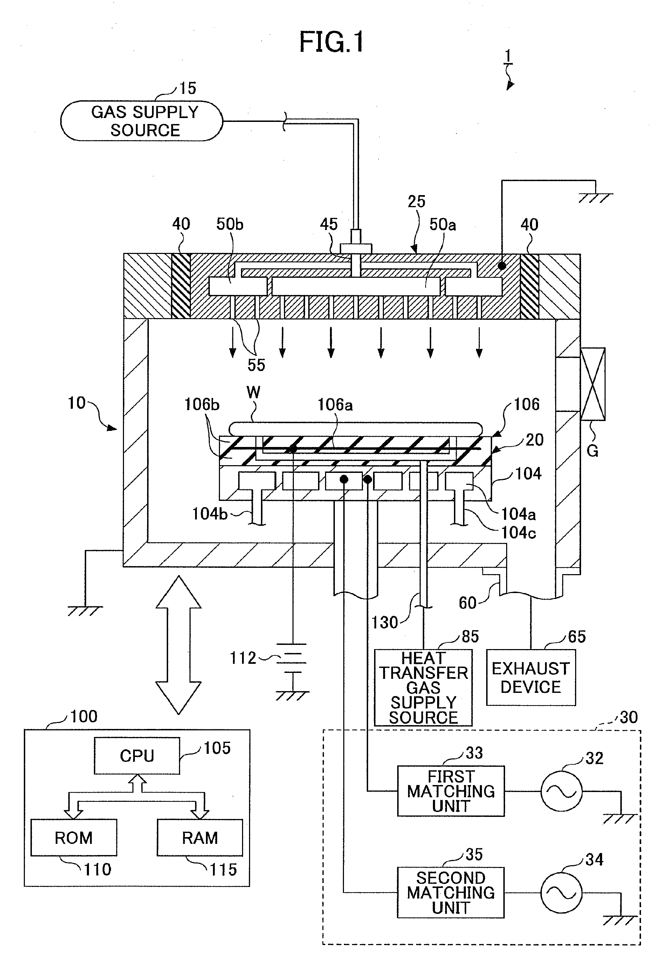

First, an overall configuration of a plasma processing apparatus according to an embodiment of the present invention is described with reference to FIG. 1. FIG. 1 is a cross-sectional view of a plasma processing apparatus 1 according to an embodiment of the present invention. Note that a parallel plate type plasma processing apparatus having a lower electrode 20 (mounting table) and an upper electrode 25 (shower head) arranged to face opposite each other within a chamber 10 (processing chamber) and being configured to supply a processing gas into the chamber 10 from the upper electrode 25 is described as an example.

The plasma processing apparatus 1 includes the chamber 10 that is made of a conductive material such as steel, for example, and a gas supply source 15 for supplying gas into the chamber 10. The chamber 10 is grounded. The gas supply source 15 is configured to supply specific gases in a wafer-less dry cleaning (hereinafter also referred to as "WLDC") process and a plasma process.

The chamber 10 is electrically grounded, and the lower electrode 20 and the upper electrode 25 that are arranged parallel to and facing opposite each other are arranged within the chamber 10. The lower electrode 20 also acts as a mounting table for holding a semiconductor wafer (hereinafter, simply referred to as "wafer"). The wafer is an example of a substrate that is subject to a plasma process.

An electrostatic chuck 106 for electrostatically attracting the wafer is provided on an upper face of the mounting table (lower electrode 20). The electrostatic chuck 106 has a chuck electrode 106a arranged between insulators 106b. A DC voltage source 112 is connected to the chuck electrode 106a, and the wafer is electrostatically attracted to the electrostatic chuck 106 by a Coulomb force that is generated when a DC voltage from the DC voltage source 112 is applied to the electrode 106a.

The mounting table is supported by a support 104. A coolant path 104a is formed within the support 104. A coolant inlet pipe 104b and a coolant outlet pipe 104c are connected to the coolant path 104a. For example, cooling water or the like may be circulated as a coolant within the coolant path 104a.

A heat transfer gas supply source 85 supplies a heat transfer gas such as helium gas (He) or argon gas (Ar) to a rear face of a wafer W that is placed on the electrostatic chuck 106 via a gas supply line 130. With such a configuration, the temperature of the electrostatic chuck 106 may be controlled by the cooling water that is circulated within the coolant path 104a and the heat transfer gas that is supplied to the rear face of the wafer W. In this way, the temperature of the wafer may be controlled to a predetermined temperature.

A power supply unit 30 for supplying dual frequency powers is connected to the lower electrode 20. The power supply unit 30 includes a first high frequency power source 32 for supplying a first high frequency power (plasma excitation frequency power) with a first frequency, and a second high frequency power source 34 for supplying a second frequency power (bias voltage generating high frequency power) with a second frequency that is lower than the first frequency. The first high frequency power source 32 is connected to the lower electrode 20 via a first matching unit 33. The second high frequency power source 34 is connected to the lower electrode 20 via a second matching unit 35. The first high frequency power source 32 may supply the first high frequency power with a frequency of 40 MHz, for example. The second high frequency power source 34 may supply the second high frequency power with a frequency of 3.2 MHz, for example.

The first and second matching units 33 and 35 are respectively configured to match the load impedance and the internal (or output) impedance of the first and second high frequency power sources 32 and 34. That is, the first and second matching units 33 and 35 are configured to present apparent matching loads between the internal impedance and the load impedance of the second high frequency power sources 32 and 34 while plasma is generated within the chamber 10.

The upper electrode 25 is mounted to a ceiling portion of the chamber 10 via a shield ring 40 that covers a peripheral portion of the upper electrode 25. The upper electrode 25 may be electrically grounded as illustrated in FIG. 1, or the upper electrode 25 may be connected to a variable DC power source (not shown) and a predetermined DC voltage may be applied to the upper electrode 25.

A gas inlet 45 for introducing gas from the gas supply source 15 is formed at the upper electrode 25. Also, a center side diffusion chamber 50a and an edge side diffusion chamber 50b are arranged within the upper electrode 25 to diffuse the gas diverged and introduced therein via the gas inlet 45.

A plurality of gas supply holes 55 for supplying gas from the diffusion chambers 50a and 50b into the chamber 10 are formed at the upper electrode 25. The gas supply holes 55 are arranged such that gas may be supplied between the upper electrode 25 and the wafer W that is placed on the lower electrode 20.

The gas from the gas supply source 15 is supplied via the gas inlet 45 into the diffusion chambers 50a and 50b where the gas is diffused and distributed to the gas supply holes 55. The gas is then discharged from the gas supply holes 55 toward the lower electrode 20. Note that the upper electrode 25 having such a configuration also serves as a gas shower head for supplying gas.

An exhaust port 60 is formed at a bottom face of the chamber 10. Gas within the chamber 10 may be evacuated by an exhaust device 65 that is connected to the exhaust port 60, and in this way, the interior of the chamber 10 may be maintained at a predetermined degree of vacuum. A gate valve G is arranged at a sidewall of the chamber 10. The gate valve G may open/close a transfer port upon loading/unloading the wafer W into/from the chamber 10.

The plasma processing apparatus 1 further includes a control unit 100 for controlling the overall operation of the apparatus. The control unit 100 includes a CPU (Central Processing Unit) 105, a ROM (Read Only Memory) 110, and a RAM (Random Access Memory) 115. The CPU 105 executes processes such as a cleaning process and a plasma process (described below) according to various recipes stored in the above storage areas. The recipes may include apparatus control information for controlling process conditions, such as the process time, the pressure (gas exhaust), the high frequency power and voltage to be applied, the flow rates of various processing gases, and the temperatures within the chamber (e.g., upper electrode temperature, chamber side wall temperature, ESC temperature), for example. Note that the recipes describing the programs and process conditions to be implemented may be stored on a hard disk or a semiconductor memory, for example, or the recipes may be stored in a portable computer-readable medium such as a CD-ROM or a DVD and written in a storage area of the control unit 100, for example.

The overall configuration of the plasma processing apparatus 1 according to an embodiment of the present invention has been described above. The plasma processing apparatus 1 having such a configuration may implement a dry cleaning method according to an embodiment of the present invention as described below, and perform a plasma process such as an etching process on a product wafer after the interior of the chamber 10 has been cleaned.

To perform a plasma process such as an etching process on a product wafer, the gate G is controlled to open/close, and a wafer W is loaded into the chamber 10 and placed on the lower electrode 20. Then, a processing gas such as an etching gas is supplied into the chamber 10, a high frequency power is applied to the lower electrode 20, and plasma is generated from the processing gas. The wafer W is thereby etched by the action of the generated plasma. After processing, the gate G is controlled to open/close and the wafer W is unloaded from the chamber 10.

### [Dry Cleaning Method]

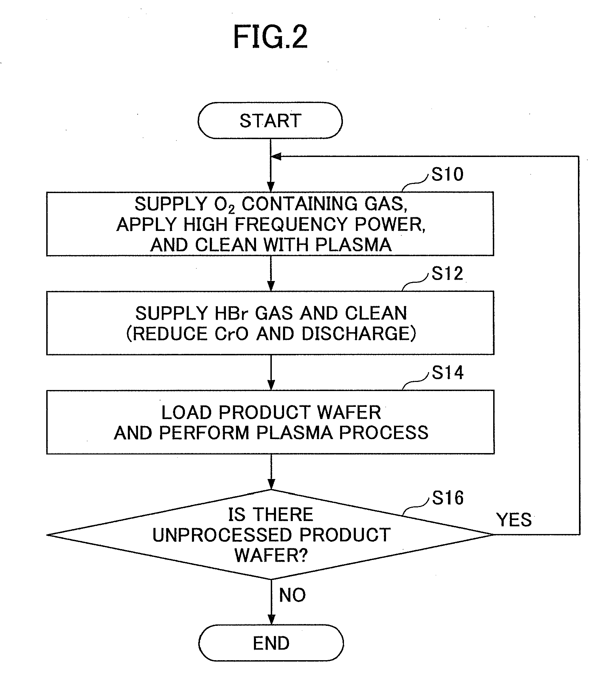

In the following, a dry cleaning method that is implemented by a plasma processing apparatus according to an embodiment of the present invention is described with reference to FIG. 2. FIG. 2 is a flowchart illustrating a dry cleaning method implemented by the plasma processing apparatus 1 according to the present embodiment. Note that the dry cleaning method according to the present embodiment is primarily controlled by the control unit 100.

### (Cleaning (Standard): First Process Step)

In the present embodiment, first, oxygen (O₂) containing gas is supplied into the chamber 10 from the gas supply source 15. The first high frequency power (plasma excitation frequency power) from the first high frequency power source 32 is applied to the lower electrode 20. The oxygen containing gas is ionized and dissociated by the energy of the high-frequency power. In this way, the interior of the chamber 10 may be cleaned by the action of O₂ plasma (step S10: first process step). For example, an organic film on the electrostatic chuck 106 may be removed by the O₂ plasma.

In the first process step, a member within the chamber 10 such as an outlet of a gas supply pipe is exposed to plasma. In this case, precipitation of chromium (Cr) contained in the stainless steel material forming the gas supply pipe may occur, and the precipitated chromium (Cr) may react with the O₂ plasma to produce chromium oxide (CrO), for example.

Note that the oxygen containing gas supplied in the first process step is an example of a first cleaning gas containing oxygen. Another example of the first cleaning gas containing oxygen includes a gas containing SF₆ gas and O₂ gas.

### (Cleaning: Second Process Step)

After the first process step, hydrogen bromide gas (HBr) is supplied into the chamber 10, and the interior of the chamber 10 is cleaned by the hydrogen bromide gas (step S12: second process step). In the second process step, the chromium oxide and hydrogen bromide gas react with one another to cause the reduction of chromium oxide to dibromide chromium (Br2Cr) as represented by the formula below.

CrO + 2HBr → H₂O + Br2Cr

The evaporation temperature of the generated dibromide chromium is 79 C° under atmospheric pressure. By generating dibromide chromium with an evaporation temperature of about 80 C° from chromium oxide using hydrogen bromide gas as described above, the dibromide chromium may be easily vaporized and evacuated from the chamber 10. In a preferred embodiment, the temperature within the chamber 10 in the cleaning step may be set to about 80 C°. Also, the chamber 10 may be held under a predetermined reduced pressure such that the evaporation temperature of the dibromide chromium may be lowered. By performing the first process step (cleaning process: O₂ plasma) of step S10 and performing the second process step (cleaning process: HBr) of step S12 thereafter, the dibromide chromium may be evacuated from the chamber 10, and in this way, metal contamination within the chamber 10 may be reduced. Note that the hydrogen bromide gas supplied in the second process step is an example of a second cleaning gas containing bromine. The second cleaning gas containing bromine may be hydrogen bromide gas alone or a mixed gas containing hydrogen bromide gas and an inert gas. For example, the second cleaning gas containing bromine may be a mixed gas containing hydrogen bromide gas and argon gas (Ar), or a mixed gas containing hydrogen bromide gas and nitrogen gas (N2).

Note that the first process step and the second process step may be a cleaning process performed in a state where a wafer is not placed on the mounting table (WLDC) or a cleaning process performed in a state where a wafer is placed on the mounting table.

### (Plasma Process Step)

After the contamination of chromium is removed from the chamber 10 by the second process step, a plasma process is performed on a product wafer. That is, a product wafer is loaded into the chamber 10, a desired processing gas is supplied, and the first high frequency power is applied to the lower electrode 20. The processing gas is ionized and dissociated by the energy of the first high frequency power, and a plasma process such as etching is performed on the product wafer by the action of the generated plasma (step S14: plasma process step).

After the plasma process, the product wafer is unloaded from the chamber 10, and the control unit 100 determines whether there is an unprocessed product wafer (step S16). Upon determining that there is an unprocessed product wafer, the control unit 100 returns to step S10, re-executes the cleaning process steps (steps S10 and S12), and executes a plasma process on the unprocessed product wafer (step S14). Note that the process steps of steps S10-S14 are repeated until the control unit 100 determines in step S16 that there is no unprocessed product wafer. Upon determining in step S16 that there is no unprocessed product wafer, the present process is terminated.

### [Reduction of Contamination Number]

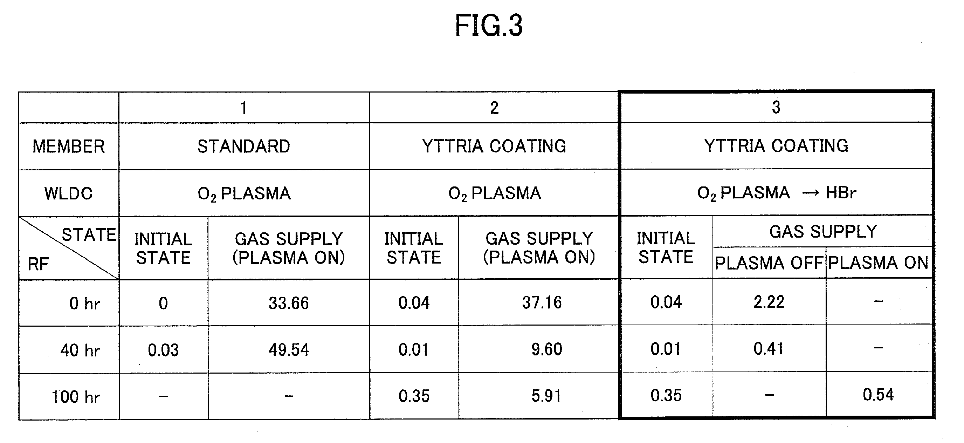

In the following, reduction of the contamination number achieved by the dry cleaning method according to the present embodiment is described with reference to FIG. 3. FIG. 3 illustrates exemplary results of executing the dry cleaning method according to the present embodiment.

Dry cleaning method 1 (standard) represents a case where a member exposed to plasma within the chamber 10 is a stainless steel member and a WLDC process using O₂ plasma (only the first process step) is performed.

Dry cleaning method 2 (yttria coating) represents a case where a member exposed to plasma within the chamber 10 is a stainless steel member coated with yttria (Y₂O₃) and a WLDC process using O₂ plasma (only the first process step) is performed. Note that the member exposed to plasma in this case may be a member containing a large amount of chromium such as an outlet of a gas supply pipe that is coated with yttria.

Dry cleaning method 3 (yttria coating) represents a case where a stainless steel member coated with yttria is exposed to plasma as in the dry cleaning method 2, and a WLDC process using O₂ plasma (first process step) is performed followed by a WLDC process using hydrogen bromide gas (second process step).

FIG. 3 illustrates measurement results of the contamination number of chromium on a wafer surface after performing the dry cleaning methods 1-3, loading a next wafer into the chamber 10, and supplying a processing gas into the chamber 10. Note that the same process conditions (steps 1-3) for the WLDC process using O₂ plasma (first process step) are implemented in the dry cleaning methods 1-3.

### <Process Conditions of First Process Step>

**• Step 1**

| | |
|---|---|
| Pressure | 5 mTorr (about 0.67 Pa) |
| First High Frequency Power | 3000 W |
| Gas Species | O₂ |
| Cleaning Time | 30 seconds |

**• Step 2**

| | |
|---|---|
| Pressure | 15 mTorr (about 2.00 Pa) |
| First High Frequency Power | 3000 W |
| Gas Species | O₂ and SF₆ |
| Cleaning Time | 40 seconds |

**• Step 3**

| | |
|---|---|
| Pressure | 20 mTorr (about 2.67 Pa) |
| First High Frequency Power | 3000 W |
| Gas Species | O₂ |
| Cleaning Time | 30 seconds |

The dry cleaning method 3 includes performing a WLDC process using hydrogen bromide gas (second process step) after performing the first process step under the above process conditions. The process conditions of the second process step are as follows.

### <Process Conditions of Second Process Step>

| | |
|---|---|
| Pressure | 90 mTorr (about 12.0 Pa) |
| First High Frequency Power | 0 W (plasma off) |
| Gas Species | HBr |
| Cleaning Time | 60 seconds |

After performing the WLDC process of the dry cleaning methods 1-3 according to the present embodiment under the above process conditions, loading the next wafer, and supplying a processing gas, the following chromium contamination numbers were measured from the wafer surface.

Note that values indicated under "initial state" of the dry cleaning methods 1-3 represent the contamination number before cleaning. The values indicated under "gas supply (plasma on)" of the dry cleaning methods 1-3 represent the contamination number of chromium on the wafer surface after plasma has been generated from a cleaning gas and cleaning has been performed by the action of the generated plasma.

The values indicated under "gas supply (plasma on)" of the dry cleaning methods 1 and 2 represent the contamination number of chromium on the wafer surface after performing the cleaning process using O₂ plasma. On the other hand, the values indicated under "gas supply (plasma off)" of the dry cleaning method 3 represents the contamination number of chromium on the wafer surface after performing the cleaning process using O₂ plasma followed by the cleaning process using hydrogen bromide gas. The value indicated under "gas supply (plasma on)" of the dry cleaning method 3 represents the contamination number of chromium on the wafer surface after performing the cleaning process using O₂ plasma followed by the cleaning process using plasma generated from the hydrogen bromide gas. That is, under "gas supply (plasma off)" of the dry cleaning method 3, plasma is not generated from the hydrogen bromide gas, whereas under "gas supply (plasma on)" of the dry cleaning method 3, plasma is generated from the hydrogen bromide gas.

Also, the first high frequency power (RF) shown vertically in the table of FIG. 3 represents the cumulative time of applying the first high frequency power (RF application time and plasma discharge time during processing of the product wafer). "0 hr" represents a case where a high frequency power is not applied. "40 hr" represents a case where a high frequency power has been applied for 40 hours.

The contamination number of FIG. 3 represents the amount of contamination atoms present on (attached to) the wafer surface per unit area that is expressed as "Contamination Number" × e¹⁰ [atoms/cm²] (area density). For example, the contamination number "33.66" of FIG. 3 indicates that chromium contamination atoms are present on the wafer surface at 33.66 × e¹⁰ atoms/cm² per unit area.

According to the results shown in FIG. 3, in the dry cleaning method 1, the initial contamination number was "0" in the case where no high frequency power was applied, and the initial contamination number was "0.03" in the case where a high frequency power was applied for 40 hours. After performing the cleaning process using O₂ plasma of the dry cleaning method 1, the contamination number was "33.66" in the case where no high frequency power was applied, and the contamination number was increased to "49.54" in the case where a high frequency power was applied for 40 hours. It can be appreciated from the above that when a cleaning process using O₂ plasma is performed, chromium is precipitated from a member that is exposed to the O₂ plasma and contamination by chromium atoms is increased.

In the dry cleaning method 2, the initial contamination number was "0.04" in the case where no high frequency power was applied, the initial contamination number was "0.01" in the case where a high frequency power was applied for 40 hours, and the initial contamination number was "0.35" in the case where a high frequency power was applied for 100 hours. After performing the cleaning process using O₂ plasma of the dry cleaning method 2, the contamination was "39.16" in the case where no high frequency power was applied, the contamination number was "9.6" in the case where a high frequency power was applied for 40 hours, and the contamination number was "5.91" in the case where a high frequency power was applied for 100 hours.

In the dry cleaning method 3, the contamination number after cleaning was further reduced. That is, the initial contamination numbers were the same as the dry cleaning method 2. On the other hand, the contamination number after performing a cleaning process using hydrogen bromide gas was "2.22" in the case where no high frequency power was applied (plasma off), and "0.41" in the case where a high frequency power was applied for 40 hours (plasma off). It can be appreciated from the above that in the dry cleaning method 3, the contamination number after cleaning can be reduced by one order of magnitude or more as compared to the dry cleaning methods 1 and 2. Note that the slightly larger contamination number "2.22" in the case where no high frequency power was applied may possibly be attributed to external factors such as having opened the chamber immediately before processing, for example.

Further, the contamination number after cleaning using hydrogen bromide gas in the dry cleaning method 3 was "0.54" in the case where a high frequency power was applied for 100 hours (plasma on). It can be appreciated from the above that the contamination number after cleaning can be reduced by one order of magnitude or more as compared to the dry cleaning methods 1 and 2. Further, in the dry cleaning method 3, even when the product wafer is processed for 100 hours, the contamination number after cleaning can be reduced by one order of magnitude or more as compared to the dry cleaning methods 1 and 2.

When a plasma process is performed on a product wafer, chromium is precipitated from a member such as a gas pipe that is exposed to the plasma. According to the dry cleaning method of the present embodiment, before performing a plasma process on a product wafer, a process step of supplying hydrogen bromide gas is implemented after a standard cleaning process step using O₂ plasma. In this way, chromium oxide that is generated during the cleaning process step using O₂ plasma may be reduced by the hydrogen bromide gas and evacuated from the chamber 10. As a result, contamination by chromium within the chamber 10 may be reduced. [Process Optimization 1]

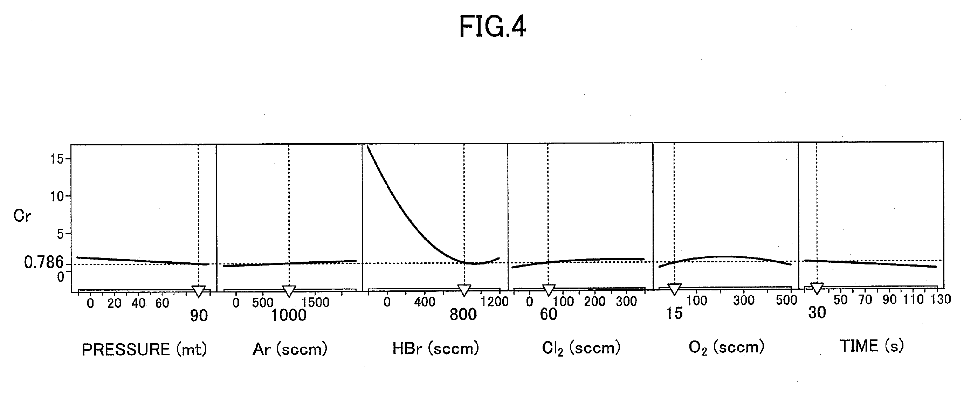

In the following, optimization of process conditions according to a first aspect of the present embodiment is described with reference to FIG. 4. FIG. 4 illustrates exemplary contamination numbers depending on process conditions of the dry cleaning method according to the present embodiment.

The horizontal axes of the graphs shown in FIG. 4 represent process conditions for the second process step of supplying hydrogen bromide gas after cleaning with O₂ plasma, and the vertical axes of the graphs represent the contamination number of chromium on the wafer surface. As can be appreciated, by performing the second process step of supplying hydrogen bromide gas after cleaning with O₂ plasma, the contamination number of chromium may be reduced. Note that the contamination number of chromium may be adequately reduced by supplying hydrogen bromide gas at approximately 800 sccm.

In contrast, it can be appreciated that no substantial reduction in the contamination number can be achieved when argon gas (Ar), chlorine gas (Cl₂), or oxygen gas (O₂) is supplied in the second process step instead of hydrogen bromide gas. One of the reasons for this may be that the evaporation temperature of dibromide chromium that is generated when hydrogen bromide gas is supplied is 79 C° at atmospheric pressure, whereas the evaporation temperature of chromium chloride (CrCl₃), for example, is 1300 C° under atmospheric pressure. As such, chromium chloride is not easily vaporized, and therefore, the contamination number of chromium may not be adequately reduced.

Also, it can be appreciated that no substantial reduction in the contamination number of chromium can be achieved by varying the pressure and cleaning time. The above results indicate that supplying hydrogen bromide gas is effective in reducing the contamination number of chromium.

### [Process Optimization 2]

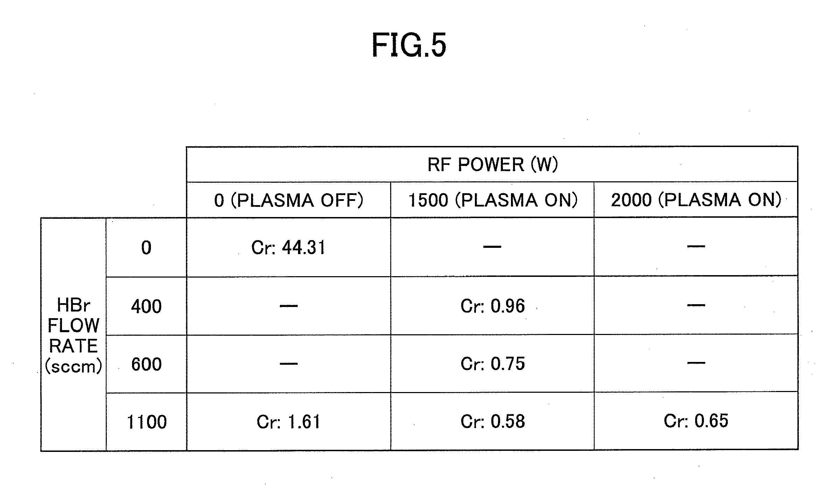

In the following, process optimization according to a second aspect of the present embodiment is described with reference to FIG. 5. FIG. 5 illustrates results of varying the first high frequency power in the dry cleaning method according to the present embodiment. In the table of FIG. 5, conditions of the first high frequency (RF) power are represented horizontally, including a case where no high frequency power is applied and a case where a first high frequency (RF) power is applied to generate plasma in the second process step. When the first high frequency power is "0 W (plasma off)", no plasma is generated. On the other hand, when the first high frequency power is "1500 W (plasma on)" or "2000 W (plasma on)", plasma is generated. Also, in the table of FIG. 5, flow rates of hydrogen bromide gas are represented vertically. The process conditions of the second process step of supplying hydrogen bromide gas are described in detail below.

### <Process Conditions>

| | |
|---|---|
| Pressure | 200 mTorr (about 26.7 Pa) |
| First High Frequency Power | 0 W, 1500 W, 2000 W |
| Gas Species | HBr |
| Cleaning Time | 30 seconds (when the first high frequency power is 1500 W or 2000 W); 60 seconds (when the first high frequency power is 0 W) |

According to the results of FIG. 5, when the second process step of supplying hydrogen bromide gas after cleaning with O₂ plasma was not performed (when the flow rate of hydrogen bromide gas was "0 sccm" and the first high frequency power was "0 W"), the contamination number of chromium was 44.31 × e¹⁰ [atoms/cm²].

In contrast, when the second process step of supplying hydrogen bromide gas was performed under the process conditions in which the flow rate of hydrogen bromide gas was "400 sccm" and the first high frequency power was "1500 W", the contamination number of chromium was 0.96 × e¹⁰ [atoms/cm²]. Under the process conditions in which the flow rate of hydrogen bromide gas was "600 sccm" and the first high frequency power was "1500 W", the contamination number of chromium was 0.75 × e¹⁰ [atoms/cm²].

Also, with respect to the case where hydrogen bromide was supplied at a flow rate of "1100 sccm" in the second process step, it can be appreciated from comparing the cases where plasma was generated (plasma on) and the case where no plasma was generated (plasma off) that the contamination number of chromium can be reduced when plasma is generated.

Based on these results, it can be appreciated that in the second process step, the contamination number of chromium may be reduced by supplying hydrogen bromide, and the contamination number of chromium may be further reduced by generating plasma from the hydrogen bromide gas.

Also, in FIG. 5, the cleaning time in the case where plasma was generated could be reduced by about a half as compared with the cleaning time in the case where no plasma was generated. That is, in the case where plasma is generated, the contamination number of chromium as well as the cleaning time may be reduced, and in turn, productivity may be increased.

Note that there is no substantial difference in the reduction efficiency of the contamination number of chromium between the case where the first high frequency power is "1500 W" and the case where the first high frequency power is "2000 W". Thus, considering the increase in cost from increasing the first high frequency power, the first high frequency power to be applied within the chamber 10 is preferably "1500 W".

Based on the above, one preferred set of process conditions for the process step of removing chromium oxide is where the pressure is 200 mT (about 26.7 Pa), the first high frequency power is 1500 W, the gas species (gas flow rate) is hydrogen bromide (1100 sccm).

According to an aspect of the dry cleaning method of the present embodiment, by supplying hydrogen bromide gas after cleaning with O₂ plasma, a chromium oxide surface layer formed on an unstable stainless steel material surface within the chamber 10 may be removed such that wafer contamination by chromium may be reduced. In this way, the device production yield may be improved, for example.

Although illustrative embodiments of a dry cleaning method and a plasma processing apparatus according to the present invention have been described above with reference to the accompanying drawings, the present invention is not limited to these embodiments. That is, numerous variations and modifications will readily occur to those skilled in the art, and the present invention includes all such variations and modifications that may be made without departing from the scope of the present invention. Also, the embodiments and modifications of the present invention may be combined to the extent practicable.

For example, the dry cleaning method according to the present invention is not limited to being implemented by a capacitively coupled plasma (CCP) processing apparatus but may also be implemented by other various types of plasma processing apparatuses including an inductively coupled plasma (ICP) processing apparatus, a chemical vapor deposition (CVD) apparatus that uses a radial line slot antenna, a helicon wave plasma (HWP) processing apparatus, and an electron cyclotron resonance plasma (ECR) processing apparatus, for example.

Also, a substrate that is subject to processing by the plasma processing apparatus according to the present invention is not limited to a semiconductor wafer but may be a large substrate for a flat panel display (FPD), an electroluminescence (EL) element, or a substrate for a solar battery, for example.

Also, the dry cleaning method according to the present invention may be implemented in a state where no substrate is placed on a mounting table or in a state where a substrate is placed on the mounting table.

Also, the dry cleaning method according to the present invention may be implemented each time a plasma process is performed on a product wafer or at some other appropriate timing after a plurality of product wafers are processed, for example.

Also, the energy applied to the chamber in the dry cleaning method according to the present invention is not limited to a high frequency power but may be a microwave power, for example. Note that a microwave has a frequency within a range of 300 MHz to 300 GHz, whereas a high frequency wave has a frequency within a range of 1 MHz to 300 MHz.

## Claims

1. A dry cleaning method implemented by a plasma processing apparatus (1) that includes a processing chamber (10) including a member containing chromium, a mounting table (20) arranged within the processing chamber and configured to hold a substrate, and a gas supply source (15) configured to supply gas into the processing chamber, the dry cleaning method comprising:
a first process step (S10) of supplying a first cleaning gas containing oxygen into the processing chamber, supplying a high frequency power or a microwave power into the processing chamber, and generating a plasma from the first cleaning gas; and
a second process step (S12) of supplying a second cleaning gas containing bromine into the processing chamber after the first process step.

2. The dry cleaning method as claimed in claim 1, wherein the second process step includes supplying a high frequency power or a microwave power into the processing chamber and generating a plasma from the second cleaning gas.

3. The dry cleaning method as claimed in claim 1 or 2, wherein the second process step includes reducing chromium oxide that is generated in the first process step and removing the chromium oxide from the processing chamber.

4. A plasma processing apparatus that is configured to perform the dry cleaning method according to any one of claims 1-3, supply a processing gas into the processing chamber after the processing chamber is cleaned by implementing the dry cleaning method, and perform a plasma process on a substrate using a plasma generated from the processing gas.
